# EUROPEAN PATENT SPECIFICATION

(11) **EP 2 299 488 B1**
(45) Date of publication and mention of the grant of the patent: **23.07.2014**
(21) Application number: 09010167.6
(22) Date of filing: 06.08.2009
(51) Int. Cl.: H01L 23/427, H01L 23/367, F28F 1/32, F28D 15/02, F28F 13/06

(54) **Heat-dissipating fin assembly with heat-conducting structure**
Wärmeableitende Rippenanordnung mit wärmeleitender Struktur
Ensemble d'ailette à dissipation de chaleur avec structure de conduction thermique

(43) Date of publication of application: 23.03.2011
(73) Proprietor: CPUMATE INC., Taipei County 248 (TW); Golden Sun News Techniques Co., Ltd., Taipei County 248 (TW)
(72) Inventor: Lin, Kuo-Len, Taipei County 248 (TW); Cheng, Chih-Hung, Taipei County 248 (TW)
(74) Representative: Wagner, Bernhard Peter

(56) References cited:
- DE-U1-202008 010 716
- US-A1- 2004 031 587
- US-A1- 2006 278 374
- US-A1- 2007 089 869
- US-A1- 2008 017 350
- US-B1- 7 215 548

## Description

### BACKGROUND OF THE INVENTION

### 1. Field of the Invention

The present invention relates to a heat-dissipating fin assembly, and in particular to a heat-dissipating fin assembly having surface processing.

### 2. Description of Prior Art

Generally speaking, a heat sink is attached to an electronic element that generates a large amount of heat, thereby dissipating the heat generated by the electronic element. The heat sink may be a heat-dissipating fin assembly and a fan, whereby the heat generated by the electronic element can be conducted to the heat-dissipating fin assembly. Then, the airflow generated by the heat-dissipating fan takes away the heat of the heat-dissipating fin assembly by means of forced airflow, thereby reducing the temperature of the electronic element.

With the highly-developed semiconductor technology, computer hardware is developed to be operated in high speed or frequency in order to improve its efficiency. As a result, the power consumed by the computer hardware also increases accordingly. The heat generated by present electronic elements is much larger than that generated by traditional electronic elements. In order to improve the heat-dissipating efficiency, Taiwan Patent Publication No. TW M295287 U discloses a plurality of air-guiding portions provided on one side of the heat-dissipating fin. The air-guiding portion is constituted of a plurality of cusps formed by a pressing process. With this arrangement, the airflow can be stayed on the heat-dissipating fin for more time and the heat-dissipating area of the heat-dissipating fin can be increased. In this way, the heat can be taken away from the heat-dissipating fin.

However, in the above structure, in order not to block the forward movement of the airflow, the air-guiding portion is constituted of a plurality of cusps, so that the surface turbulence and the heat-dissipating area can be only increased to a limited extent. Thus, it is an important issue to provide a heat-dissipating fin assembly that generates more turbulence and has a larger heat-dissipating area so as to increase the heat-exchange efficiency.

US patent application publication No. 2006/0278374 discloses a heat sink composed of heat pipes and fins having protrusions. Each the fin is provided with identical protrusions. In other words, the shape of each the fin is the same. Therefore, the protrusions of a fin are correspondingly embedded into the recesses formed by backsides of the protrusions of another adjacent fin.

Also, US patent application publication No. 2007/0089869 discloses a similar heat sink. The protrusion on the fin causes a larger surface area than an entirely flat fin, the gap between two adjacent fins are not enough to allow a large amount of air to pass through.

German patent application publication No. DE 20 2008 010 716 U discloses a heat sink consisting of a plurality of stacked heat dissipating fins each provided with through holes through which heat pipes pass. Each heat dissipating fin comprises a central rib protruding to one side of the fin and bent rim portions extending in parallel to the central rib and protruding to the other side of the fin. The rim portions define the distance between two adjacent fins.

US patent application publication No. 2004/0031587 discloses a heat-exchanging fin device. The fin device comprises at least two fin plates. Each fin plate comprises parallel adjacent straight banks. Each bank has the same width and comprises convex portions and concave portions. The concave portions and convex portions are alternatively arranged. Each of the concave portions and convex portions has a U-like shape. Such a design is very complicated in structure because the fin plate is not like a "plate" any more. It has been completely deformed into a continuously waved shape. This so-called "fin plate" is very hard to be manufactured.

### SUMMARY OF THE INVENTION

The object of the present invention is to provide a heat-dissipating fin assembly with heat-conducting structure, whereby the surface turbulence and the heat-dissipating area of the heat-dissipating fin can be increased so as to enhance the heat-exchange efficiency.

This object is achieved by the subject matter of claim 1.

Thus, the present invention provides a heat-dissipating fin assembly with heat-conducting structure, whose one side is provided with an air-guiding piece for guiding airflow into channels among the heat-dissipating fins.

In comparison with prior art, since the first heat-dissipating fin and the second heat-dissipating fin are provided with a plurality of corresponding first protrusions and second protrusions respectively, the first protrusions and the second protrusions that are arranged at intervals and correspond to each other can increase the surface turbulent between the first heat-dissipating fin and the second heat-dissipating fin. Thus, the forward movement of airflow will not be affected while the heat-dissipating area there between can be increased. Therefore, the heat-exchange efficiency can be enhanced.

### BRIEF DESCRIPTION OF THE DRAWINGS

FIG 1 is a perspective view showing the external appearance of the first heat-dissipating fin of the present invention;
FIG 2 is an assembled perspective view showing the first and second heat-dissipating fins of the present invention;
FIG 3 is an assembled top view showing the first and second heat-dissipating fins of the present invention;
FIG 4 is a partially cross-sectional view taken along the line 4-4 in FIG. 3;
FIG 5 is a schematic view (I) showing the operating state of the heat-dissipating fin of the present invention;
FIG 6 is a schematic view (II) showing the operating state of the heat-dissipating fin of the present invention;
FIG 7 is an assembled top view showing the first and second heat-dissipating fins according to the second embodiment of the present invention; and
FIG 8 is a partially assembled cross-sectional view showing the first and second heat-dissipating fins according to the second embodiment of the present invention.

### DETAILED DESCRIPTION OF THE INVENTION

The characteristics and technical contents of the present invention will be described with reference to the accompanying drawings. However, the drawings are illustrative only but not used to limit the present invention.

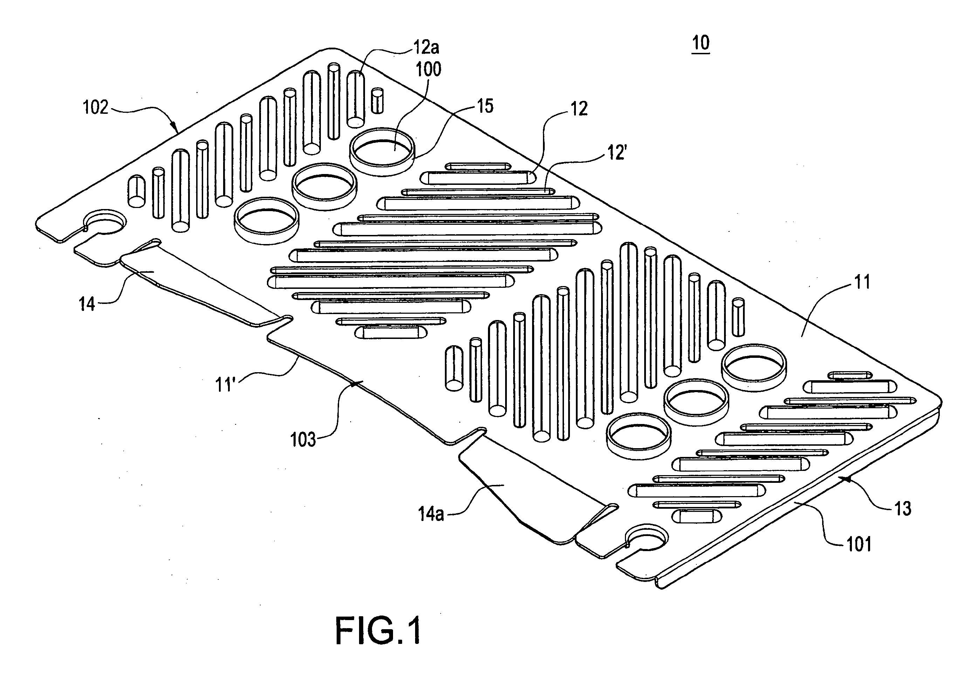

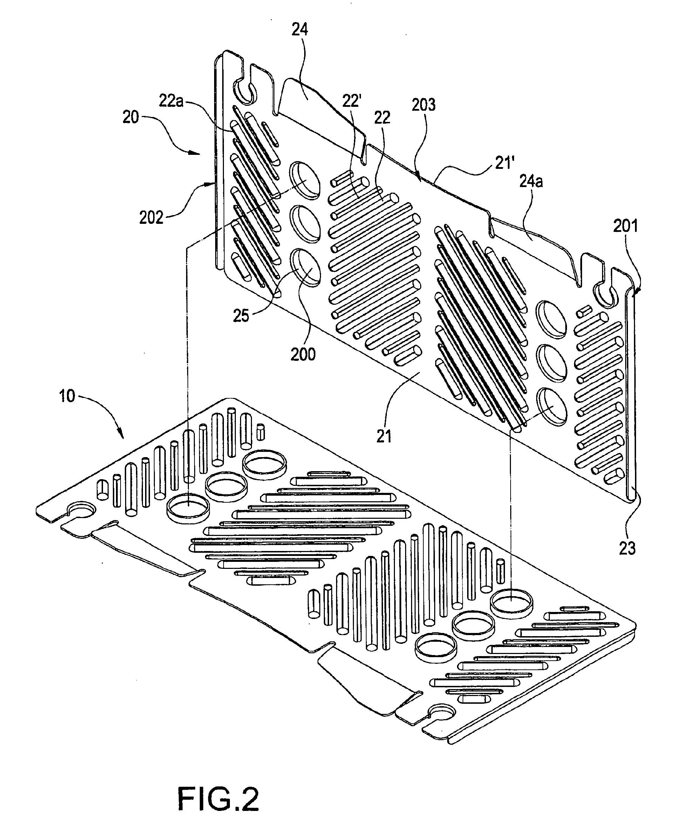

Please refer to FIGs. 1 and 2, which are perspective views showing the external appearance of the heat-dissipating fin assembly of the present invention. The heat-dissipating fin assembly of the present invention includes a first heat-dissipating fin 10 and a second heat-dissipating fin 20 that are overlapped with each other.

The first heat-dissipating fin 10 has a first surface 11. The first surface 11 is provided with a plurality of first protrusions 12. Each of the first protrusion 12 is a rib. The first protrusions 12 are arranged at intervals and parallel to one another obliquely. Each of the two opposite sides 101, 102 of the first heat-dissipating fin 10 is perpendicularly bent toward the same direction to form a first bending piece 13, so that a gap can be formed between the first heat-dissipating fin 10 and the second heat-dissipating fin 20 by supporting of the first bending pieces 13 when they are overlapped with each other. The height of the first bending piece 13 is larger than that of the first protrusion 12. The other side of the first heat-dissipating fin 10 that is perpendicular to the first bending piece 13 is provided with two first air-guiding pieces 14, 14a. The two first air-guiding pieces 14, 14a form an opposite inclined angle with respect to the first surface 11 respectively. However, those skilled in this art may appreciate that the number and arrangement of the air-guiding pieces can be changed according to practical demands. Alternatively, there may be only one air-guiding piece.

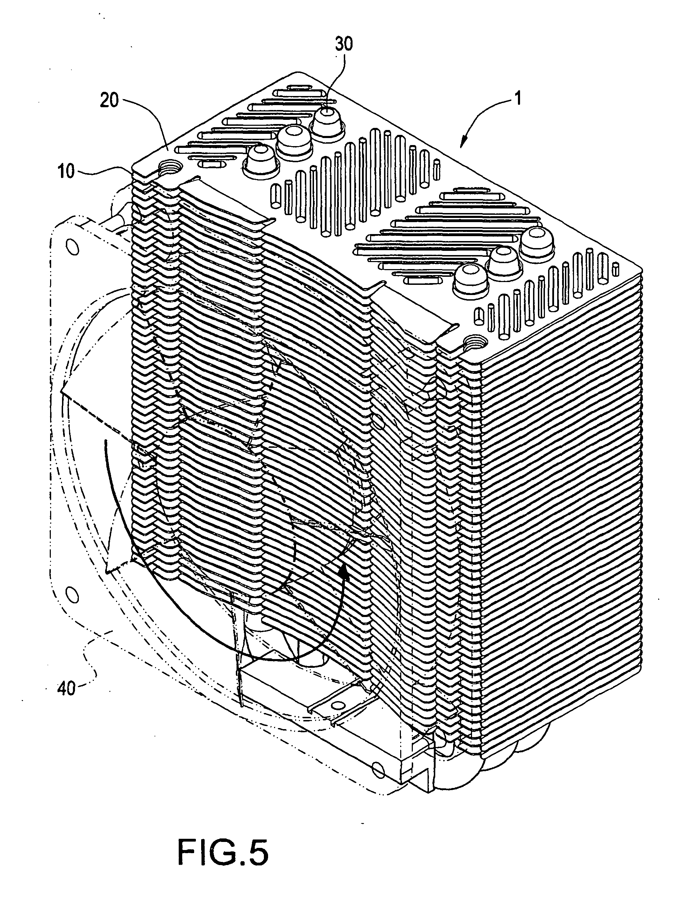

Furthermore, the first heat-dissipating piece 10 can be provided with a plurality of through-holes 100 for allowing at least one heat pipe 30 (FIG 5) to penetrate therein. The first heat-dissipating fm 10 is provided with a flange 15 at the periphery of the through-hole 100 so as to increase the contact area between the first heat-dissipating fin 10 and the heat pipe 30. Further, in order to increase the turbulence and the heat-dissipating area, the first heat-dissipating fin 10 is provided with a plurality of other first protrusions 12a. The first protrusions 12, 12a are located on both sides of the through-hole 100 and are oriented in opposite directions. Since the heat-dissipating fins are overlapped with each other, the other surface 11' of the first heat-dissipating fin 10 opposite to the first surface 11 is provided with a plurality of second protrusions 12'. The second protrusions 12' on the other surface 11' are staggered with respect to the second protrusions 12 on the first surface 11. Since the heat-dissipating fins are made of materials of good heat-dissipating property (such as aluminum), the ribs on its surface can be formed by means of a pressing process. Thus, the other surface of the rib forms a trough. As a result, the second protrusions 12' form a plurality of troughs on the first surface 11.

The second heat-dissipating fins 20 are overlapped with the first heat-dissipating fins 10. The arrangement of the second heat-dissipating fin 20 is substantially the same as that of the first heat-dissipating fin 10 and has a second surface 21 toward the first surface 11. The second surface 21 is provided with a plurality of second protrusions 22, 22a. The arrangement of the second protrusions 22, 22a correspond to that of the first protrusions 12, 12a. The second protrusions 22, 22a are ribs arranged at intervals and parallel to one another obliquely. The opposite two sides 201, 202 of the second heat-dissipating fin 20 are bent toward the same side to form a second bending piece 23, while the other side 203 is provided with two first air-guiding pieces 24, 24a. The second heat-dissipating fin 20 is provided with a through-hole 200 and a second flange 25 to correspond to the first heat-dissipating fin 10. The difference between the second heat-dissipating fin 20 and the first heat-dissipating fin 10 lies in that: the second protrusions 22, 22a are arranged obliquely in a direction opposite to that of the first protrusions 12, 12a. That is to say, the second protrusions 22, 22a are staggered with respect to the first protrusions 12, 12a. Similarly, the second heat-dissipating fin 20 is also provided with a plurality of second protrusions 22' on the other surface 21' opposite to the second surface 21.

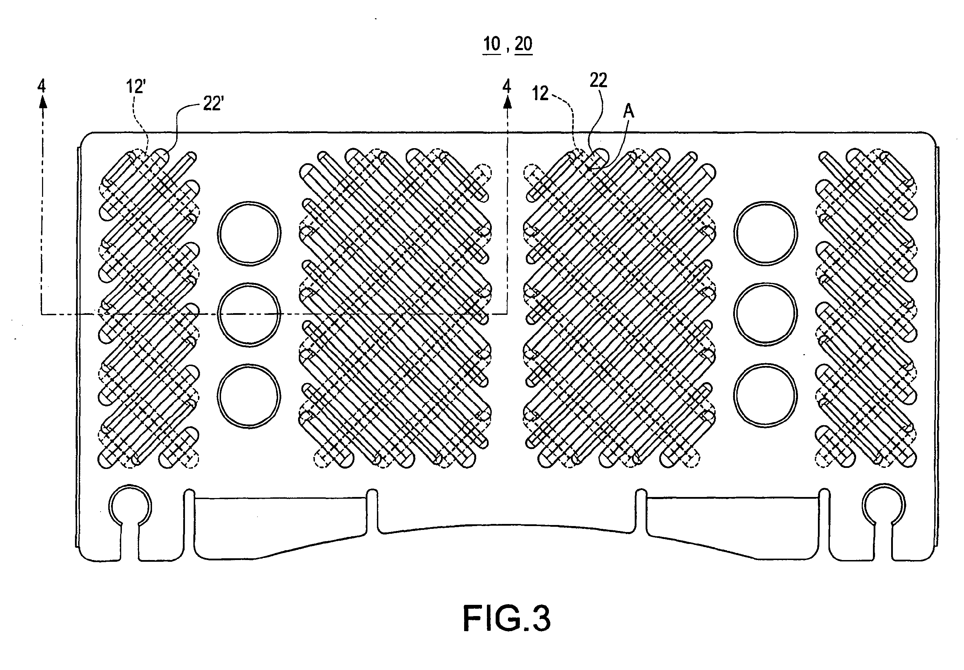

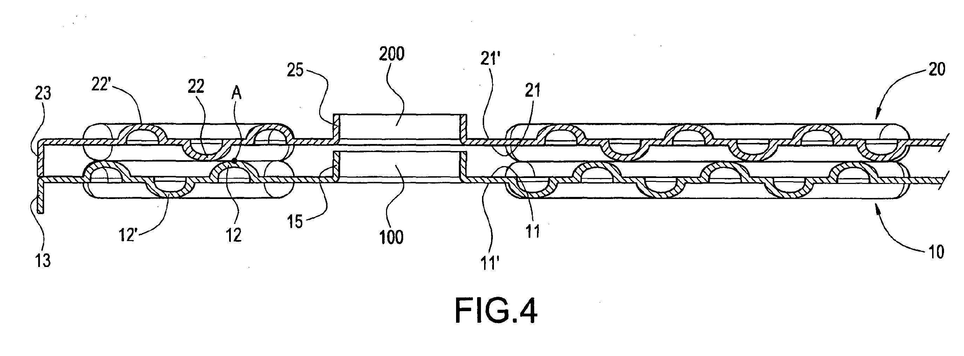

Please refer to FIG. 3 and 4, which are a top view and a cross-sectional view showing the overlapping of the first heat-dissipating fin 10 and the second heat-dissipating fin 20. It can be seen that, when overlapped, the first protrusions 12 and the second protrusions 22 are staggered to form a plurality of contacting points A. The second bending piece 23 is overlapped on the first bending piece 13, so that an airflow channel is formed there between.

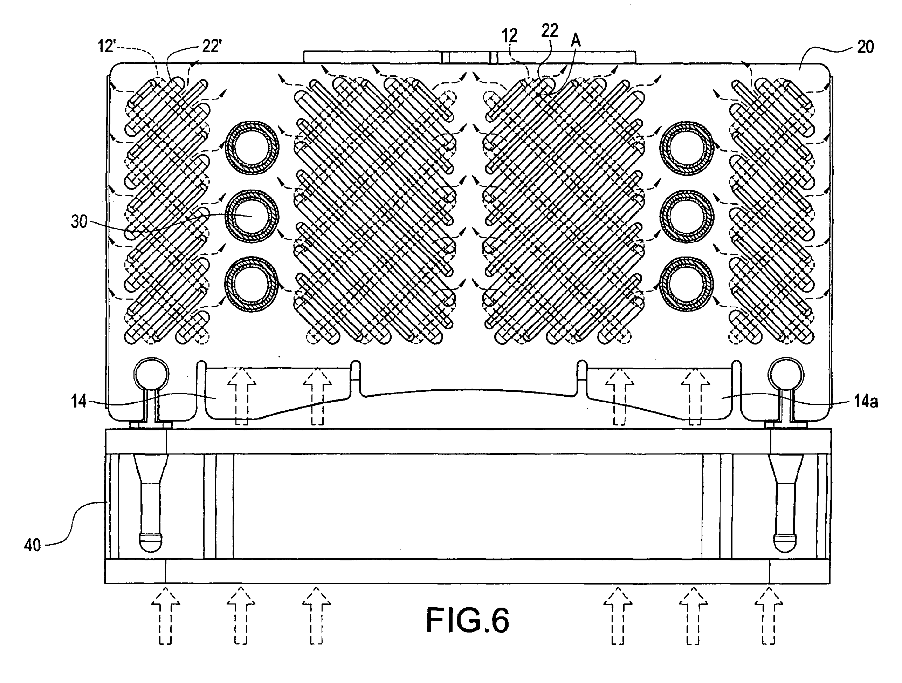

Please refer to FIGS. 5 and 6, which show the operating state of the heat-conducting structure of the heat-dissipating fin of the present invention. In the following, the elements of the first heat-dissipating fin 10 and the second heat-dissipating fin 20 are described as an example. In use, the first heat-dissipating fins 10 and the second heat-dissipating fins 20 are overlapped orderly to form a heat-dissipating fin assembly 1. Further, a plurality of heat pipes 30 penetrates into the heat-dissipating fin assembly 1. One side of the heat-dissipating fin assembly 1 is provided with an axial fan 40. The airflow generated by the axial fan 40 is guided by the two second air-guiding pieces 14, 14a into the heat-dissipating fin assembly 1. The airflow entering the airflow channels passes through the staggered first protrusions 12 and the second protrusions 22 to generate turbulence. Since the first protrusions 12 and the second protrusions 22 are brought into point contact with each other, the forward movement of the airflow will not be affected. The generation of the turbulence can extend the time for the airflow to stay in the channels, thereby taking away more heat of the heat-dissipating fins to enhance the heat-exchange efficiency. Further, the first protrusions 12 and the second protrusions 22 increase the heat-dissipating area of the first heat-dissipating fins 10 and the second heat-dissipating fins 20, thereby facilitating the turbulence to take away more heat and accelerating the heat dissipation.

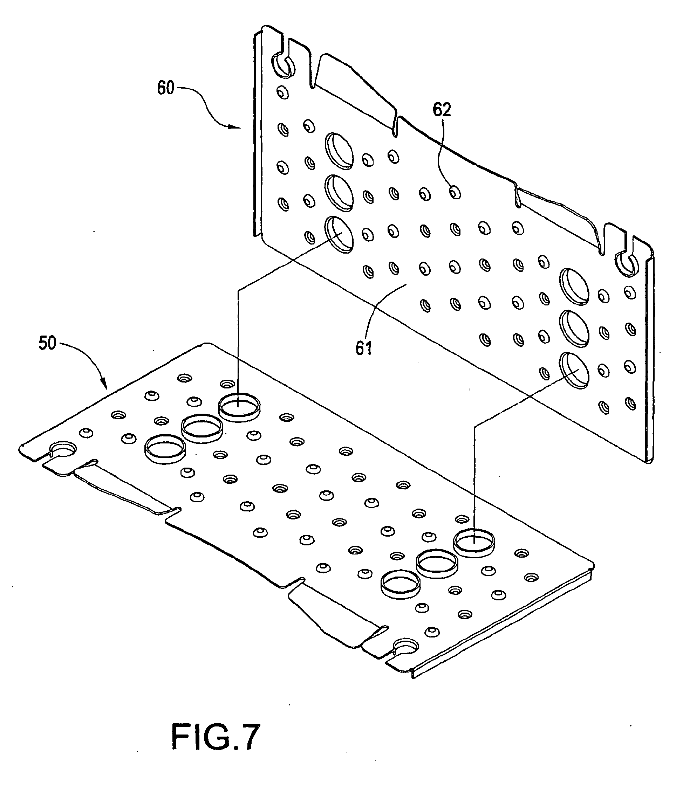

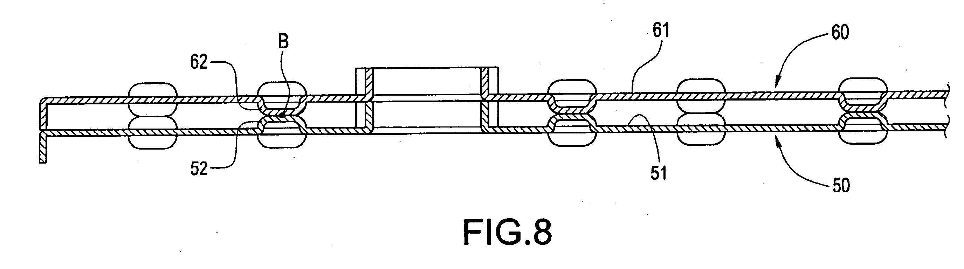

Please refer to FIGS. 7 and 8, which are a top view and a cross-sectional view showing the overlapping of the first heat-dissipating fin and the second heat-dissipating fin according to the second embodiment of the present invention. The second embodiment is substantially identical to the first embodiment, and it has a first heat-dissipating fin 50 and a second heat-dissipating fin 60. A first surface 51 of the first heat-dissipating fin 50 is provided with a first protrusion 51. A first surface 61 of the second heat-dissipating fin 60 is provided with a second protrusion 61. The only difference lies in that each of the first protrusion 51 and the second protrusion 61 is a semi sphere. It can be seen that, when overlapped, the first protrusions 52 and the second protrusions 62 are brought into contact with each other to form a plurality of contact points B.

## Claims

1. A heat-dissipating fin assembly, comprising:
a first heat-dissipating fin (10) having a first surface (11), the first surface (11) being provided with a plurality of first protrusions (12) arranged at intervals;
a second heat-dissipating fin (20) overlapped with the first heat-dissipating fin (10) and having a second surface (21) toward the first surface (11), the second surface (21) being provided with a plurality of second protrusions (22) arranged at intervals, the second protrusions (22) being arranged to correspond to the first protrusions (12);
wherein the first and the second heat-dissipating fins (10, 20) are each provided with a through-hole (100, 200) for allowing a heat pipe (30) to penetrate therein, the first and the second heat-dissipating fins (10) are respectively provided with a first and a second flange (15, 25) at a periphery of the through-holes (100);
**characterized in that** the first protrusions (12) and the second protrusions (22) are protrudent toward the second heat-dissipating fin (20) and the first heat-dissipating fin (10), respectively, wherein the first protrusions (12) and the second protrusions (22) are brought into point contact.

2. The heat-dissipating fin assembly according to claim 1, wherein the first heat-dissipating fin (10) is provided with a plurality of other first protrusions (12a), the first protrusions (12) and the other first protrusions (12a) are provided on both sides of the through-hole (100) respectively.

3. The heat-dissipating fin assembly according to claim 1, wherein the second heat-dissipating fin (20) is provided with a plurality of other second protrusions (22a), the second protrusions (22) and the other second protrusions (22a) are provided on both sides of the through-hole (100) respectively.

4. The heat-dissipating fin assembly according to claim 1, wherein each of two opposite sides (101, 102) of the first heat-dissipating fin (10) is bent toward the same side to form a first bending piece (13), thereby forming a gap when the first heat-dissipating fin (10) is overlapped with the second heat-dissipating fin (20).

5. The heat-dissipating fin assembly according to claim 4, wherein the height of the first bending piece (13) is larger than that of the first protrusion (12).

6. The heat-dissipating fin assembly according to claim 4, wherein an another side (103) of the first heat-dissipating fin (10) that is perpendicular to the first bending piece (13) is provided with two first air-guiding pieces (14, 14a), and the two first air-guiding pieces (14, 14a) are inclined reversely with respect to the first surface (11).

7. The heat-dissipating fin assembly according to claim 1, wherein an another surface (11') of the first heat-dissipating fin (10) opposite to the first surface (11) is provided with a plurality of first protrusions (12'), and the first protrusions (12') on the another surface (11') are staggered with respect to the first protrusions (12) on the first surface (11).

8. The heat-dissipating fin assembly according to claim 1, wherein two opposite sides (201, 202) of the second heat-dissipating fin (20) are bent toward the same side to form a second bending piece (23), thereby forming a gap when the second heat-dissipating fin (20) is overlapped with the first heat-dissipating fin (10).

9. The heat-dissipating fin assembly according to claim 8, wherein the height of the second bending piece (23) is larger than that of the second protrusion (22).

10. The heat-dissipating fin assembly according to claim 8, wherein the other side (203) of the second heat-dissipating fin (20) that is perpendicular to the second bending piece (23) is provided with two second air-guiding pieces (24, 24a), the two air-guiding pieces (24, 24a) are inclined reversely with respect to the second surface (21).

11. The heat-dissipating fin assembly according to claim 1, wherein the other surface (21') of the second heat-dissipating fin (20) opposite to the second surface (21) is also provided with a plurality of other second protrusions (22'), the second protrusions (22') on the other surface (21') are staggered with respect to the second protrusions (22) on the second surface (21).

12. The heat-dissipating fin assembly according to claim 1, wherein each of the first protrusion (12) and the second protrusion (22) is a rib, the first protrusions (12) and the second protrusions (22) are arranged at intervals and parallel to each other obliquely, the second protrusions (22) are inclined in a direction opposite to that of the first protrusions (12).

13. The heat-dissipating fin assembly according to claim 1, wherein each of the first protrusion (12) and the second protrusion (22) is a semi sphere, the first protrusion (12) and the second protrusion (22) are brought into contact with each other.

## Patentansprüche

1. Wärmeabführende Lamellenanordnung, die umfasst:
eine erste wärmeabführende Lamelle (10), die eine erste Oberfläche (11) besitzt, wobei die erste Oberfläche (11) mit mehreren ersten Ausstülpungen (12) versehen ist, die in Intervallen angeordnet sind;
eine zweite wärmeabführende Lamelle (20), die mit der ersten wärmeabführenden Lamelle (10) überlappt und die eine zweite Oberfläche (21) in Richtung der ersten Oberfläche (11) besitzt, wobei die zweite Oberfläche (21) mit mehreren zweiten Ausstülpungen (22) versehen ist, die in Intervallen angeordnet sind und wobei die zweiten Ausstülpungen (22) angeordnet sind, um den ersten Ausstülpungen (12) zu entsprechen;
wobei die erste und die zweite wärmeabführende Lamelle (10, 20) jeweils mit einem Durchgangsloch (100, 200) versehen sind, um zuzulassen, dass ein Wärmerohr (30) dort eindringt, wobei die erste und die zweite wärmeabführende Lamelle (10) jeweils mit einem ersten und einem zweiten Flansch (15, 25) an einem Umfang der Durchgangslöcher (100) versehen sind;
**dadurch gekennzeichnet, dass** die ersten Ausstülpungen (12) und die zweiten Ausstülpungen (22) jeweils in Richtung der zweiten wärmeabführenden Lamelle (20) und der ersten wärmeabführenden Lamelle (10) ausgestülpt sind, wobei die ersten Ausstülpungen (12) und die zweiten Ausstülpungen (22) in Punktkontakt gebracht sind.

2. Wärmeabführende Lamellenanordnung nach Anspruch 1, wobei die erste wärmeabführende Lamelle (10) mit mehreren anderen ersten Ausstülpungen (12a) versehen ist und wobei die ersten Ausstülpungen (12) und die anderen ersten Ausstülpungen (12a) jeweils auf beiden Seiten des Durchgangslochs (100) vorgesehen sind.

3. Wärmeabführende Lamellenanordnung nach Anspruch 1, wobei die zweite wärmeabführende Lamelle (20) mit mehreren anderen zweiten Ausstülpungen (22a) versehen ist und wobei die zweiten Ausstülpungen (22) und die anderen zweiten Ausstülpungen (22a) jeweils auf beiden Seiten des Durchgangslochs (100) vorgesehen sind.

4. Wärmeabführende Lamellenanordnung nach Anspruch 1, wobei jede der zwei gegenüberliegenden Seiten (101, 102) der ersten wärmeabführenden Lamelle (10) in Richtung der gleichen Seite gebogen ist, um ein erstes Biegungsstück (13) auszubilden, wodurch eine Lücke gebildet wird, wenn die erste wärmeabführende Lamelle (10) mit der zweiten wärmeabführenden Lamelle (20) überlagert wird.

5. Wärmeabführende Lamellenanordnung nach Anspruch 4, wobei die Höhe des ersten Biegungsstücks (13) größer als die der ersten Ausstülpung (12) ist.

6. Wärmeabführende Lamellenanordnung nach Anspruch 4, wobei eine weitere Seite (103) der ersten wärmeabführenden Lamelle (10), die senkrecht zu dem ersten Biegungsstück (13) ist, mit zwei ersten Luftleitstücken (14, 14a) versehen ist und die zwei ersten Luftleitstücke (14, 14a) in Bezug auf die erste Oberfläche (11) umgekehrt geneigt sind.

7. Wärmeabführende Lamellenanordnung nach Anspruch 1, wobei eine weitere Oberfläche (11') der ersten wärmeabführenden Lamelle (10), die der ersten Oberfläche (11) gegenüberliegt, mit mehreren ersten Ausstülpungen (12') versehen ist und die ersten Ausstülpungen (12') auf der weiteren Oberfläche (11') in Bezug auf die ersten Ausstülpungen (12) auf der ersten Oberfläche (11) versetzt angeordnet sind.

8. Wärmeabführende Lamellenanordnung nach Anspruch 1, wobei zwei gegenüberliegende Seiten (201, 202) der zweiten wärmeabführenden Lamelle (20) in Richtung der gleichen Seite gebogen sind, um ein zweites Biegungsstück (23) auszubilden, wodurch eine Lücke gebildet wird, wenn die zweite wärmeabführende Lamelle (20) mit der ersten wärmeabführenden Lamelle (10) überlagert wird.

9. Wärmeabführende Lamellenanordnung nach Anspruch 8, wobei die Höhe des zweiten Biegungsstücks (23) größer als jene der zweiten Ausstülpung (22) ist.

10. Wärmeabführende Lamellenanordnung nach Anspruch 8, wobei die andere Seite (203) der zweiten wärmeabführenden Lamelle (20), die senkrecht zu dem zweiten Biegungsstück (23) ist, mit zwei zweiten Luftleitstücken (24, 24a) versehen ist und die zwei zweiten Luftleitstücke (24, 24a) in Bezug auf die zweite Oberfläche (21) umgekehrt geneigt sind.

11. Wärmeabführende Lamellenanordnung nach Anspruch 1, wobei die andere Oberfläche (21') der zweiten wärmeabführenden Lamelle (20), die der zweiten Oberfläche (21) gegenüberliegt, auch mit mehreren anderen zweiten Ausstülpungen (22') versehen ist und die zweiten Ausstülpungen (22') auf der anderen Oberfläche (21') in Bezug auf die zweiten Ausstülpungen (22) auf der zweiten Oberfläche (21) versetzt angeordnet sind.

12. Wärmeabführende Lamellenanordnung nach Anspruch 1, wobei sowohl die erste Ausstülpung (12) als auch die zweite Ausstülpung (22) jeweils eine Rippe ist, wobei die ersten Ausstülpungen (12) und die zweiten Ausstülpungen (22) in Intervallen und parallel zueinander schief angeordnet sind und wobei die zweiten Ausstülpungen (22) in eine Richtung geneigt sind, die zu jener der ersten Ausstülpungen (12) entgegengesetzt ist.

13. Wärmeabführende Lamellenanordnung nach Anspruch 1, wobei sowohl die erste Ausstülpung (12) als auch die zweite Ausstülpung (22) jeweils eine Halbkugel ist und wobei die erste Ausstülpung (12) und die zweite Ausstülpung (22) miteinander in Kontakt gebracht sind.

## Revendications

1. Assemblage à ailettes de dissipation de chaleur, comprenant :
une première ailette de dissipation de chaleur (10) ayant une première surface (11), la première surface (11) étant dotée d'une pluralité de premières projections (12) agencées à intervalles ;
une seconde ailette de dissipation de chaleur (20) en recouvrement avec la première ailette de dissipation de chaleur (10) et ayant une seconde surface (21) vers la première surface (11), la seconde surface (21) étant dotée d'une pluralité de secondes projections (22) agencées à intervalles, les secondes projections (22) étant agencées pour correspondre aux premières projections (12) ;
dans lequel la première et la seconde ailette de dissipation de chaleur (10, 20) sont dotées chacune d'un trou traversant (100, 200) pour permettre à un caloduc (30) de pénétrer à l'intérieur, la première et la seconde ailette de dissipation de chaleur (10) étant respectivement dotée d'une première et d'une seconde bride (15, 25) à une périphérie des trous traversants (100) ;
**caractérisé en ce que** les premières projections (12) et les secondes projections (22) se projettent vers la seconde ailette de dissipation de chaleur (20) et vers la première ailette de dissipation de chaleur (10), respectivement, et **en ce que** les premières projections (12) et les secondes projections (22) sont amenées en contact ponctuel.

2. Assemblage à ailettes de dissipation de chaleur selon la revendication 1, dans lequel la première ailette de dissipation de chaleur (10) est dotée d'une pluralité d'autres premières projections (12a), les premières projections (12) et les autres premières projections (12a) étant prévues sur les deux côtés du trou traversant (100) respectivement.

3. Assemblage à ailettes de dissipation de chaleur selon la revendication 1, dans lequel la seconde ailette de dissipation de chaleur (20) est dotée d'une pluralité d'autres secondes projections (22a), les secondes projections (22) et les autres secondes projections (22a) étant prévues sur les deux côtés du trou traversant (100) respectivement.

4. Assemblage à ailettes de dissipation de chaleur selon la revendication 1, dans lequel chacun des deux côtés opposés (101, 102) de la première ailette de dissipation de chaleur (10) est cintré vers le même côté pour former une première pièce cintrée (13), en formant ainsi un intervalle quand la première ailette de dissipation de chaleur (10) est en chevauchement avec la seconde ailette de dissipation de chaleur (20).

5. Assemblage à ailettes de dissipation de chaleur selon la revendication 4, dans lequel la hauteur de la première pièce cintrée (13) est plus grande que celle de la première projection (12).

6. Assemblage à ailettes de dissipation de chaleur selon la revendication 4, dans lequel un autre côté (103) de la première ailette de dissipation de chaleur (10) qui est perpendiculaire à la première pièce cintrée (13) est pourvu de deux premières pièces de guidage d'air (14, 14a), et les deux premières pièces de guidage d'air (14, 14a) sont inclinées en sens inverse par rapport à la première surface (11).

7. Assemblage à ailettes de dissipation de chaleur selon la revendication 1, dans lequel une autre surface (11') de la première ailette de dissipation de chaleur (10) à l'opposé de la première surface (11) est dotée d'une pluralité de premières projections (12'), et les premières projections (12') sur l'autre surface (11') sont échelonnées par rapport aux premières projections (12) sur la première surface (11).

8. Assemblage à ailettes de dissipation de chaleur selon la revendication 1, dans lequel deux côtés opposés (201, 202) de la seconde ailette de dissipation de chaleur (20) sont cintrés vers le même côté pour former une seconde pièce cintrée (23), en formant ainsi un intervalle quand la seconde ailette de dissipation de chaleur (20) est en chevauchement avec la première ailette de dissipation de chaleur (10).

9. Assemblage à ailettes de dissipation de chaleur selon la revendication 8, dans lequel la hauteur de la seconde pièce cintrée (23) est plus grande que celle de la seconde projection (22).

10. Assemblage à ailettes de dissipation de chaleur selon la revendication 8, dans lequel l'autre côté (103) de la seconde ailette de dissipation de chaleur (20) qui est perpendiculaire à la seconde pièce cintrée (23) est pourvu de deux secondes de pièces de guidage d'air (24, 24a), les deux pièces de guidage d'air (24, 24a) étant inclinées en sens inverse par rapport à la seconde surface (21).

11. Assemblage à ailettes de dissipation de chaleur selon la revendication 1, dans lequel l'autre surface (21') de la seconde ailette de dissipation de chaleur (20) à l'opposé de la seconde surface (21) est également dotée d'une pluralité d'autres secondes projections (22'), les secondes projections (22') sur l'autre surface (21') étant échelonnées par rapport aux secondes projections (22) sur la seconde surface (21).

12. Assemblage à ailettes de dissipation de chaleur selon la revendication 1, dans lequel chacune de la première projection (12) et de la seconde projection (22) est une nervure, les premières projections (12) et les secondes projections (22) étant agencées à intervalles et parallèles les unes aux autres en oblique, les secondes projections (22) étant inclinées dans une direction opposée à celle des premières projections (12).

13. Assemblage à ailettes de dissipation de chaleur selon la revendication 1, dans lequel chacune de la première projection (12) et de la seconde projection (22) a une forme hémisphérique, la première projection (12) et la seconde projection (22) étant amenées en contact l'une avec l'autre.
